Europäisches Patentamt

(19) European Patent Office

Office européen des brevets

(11) Publication number: **0 106 378**
**A1**

(12) # EUROPEAN PATENT APPLICATION

(21) Application number: **83201226.4**

(22) Date of filing: **25.08.83**

(51) Int. Cl.³: **H 03 F 1/52**

(30) Priority: **20.09.82 BE 2059840**

(43) Date of publication of application:
**25.04.84 Bulletin 84/17**

(84) Designated Contracting States:
**AT BE CH DE FR GB IT LI LU NL SE**

(71) Applicant: **BELL TELEPHONE MANUFACTURING COMPANY Naamloze Vennootschap Francis Wellesplein 1 B-2000 Antwerp(BE)**

(84) Designated Contracting States:
**BE LU NL**

(71) Applicant: **International Standard Electric Corporation 320 Park Avenue New York New York 10022(US)**

(84) Designated Contracting States:
**CH DE FR GB IT LI SE AT**

(72) Inventor: **Bienstman, Luc Armand Geerdegemvaart 145 B-2800 Mechelen(BE)**

(74) Representative: **Vermeersch, Robert et al, BELL TELEPHONE MANUFACTURING COMPANY Naamloze Vennootschap Patent Department Francis Wellesplein 1 B-2000 Antwerp(BE)**

(54) Electronic power overload protection circuit.

(57) Electronic power overload protection circuit adapted to limit the output power of a signal amplifier (Q1/2, 11/14) with the help of a sensing element (Q16/19) part of a feedback circuit for said amplifier and which becomes conductive upon a predetermined maximum output power threshold being reached. Threshold selection means (Q12, 34/15, 35) are provided so that said threshold may correspond (R10/12) to a constant amplifier output current and amplifier temperature sensing means (Q37) are provided to prevent said threshold from corresponding to said constant amplifier output current once the temperature exceeds a predetermined maximum (160°C).

./...

Croydon Printing Company Ltd

FIG.3

FIG.4

ELECTRONIC POWER OVERLOAD PROTECTION CIRCUIT

The invention relates to an electronic power overload protection circuit adapted to limit the output power of a signal amplifier with the help of a sensing element part of a feedback circuit for said amplifier and which becomes conductive upon a predetermined maximum output power threshold being reached.

Such a protection circuit for push-pull amplifier output transistors is known from the published European patent application 0058005 in which the sensing element is a transistor so associated to the output transistor that the square of its collector current is a linear function of the output transistor collector current and of the product of the latter by the collector-emitter voltage of the output transistor. The protection operation start level can be selected by modifying the parameters of the sensing and other associated transistors and resistors but the protection circuit is always active and thus continuously consumes power.

A general object of the invention is to provide a power overload circuit for such output transistors in which the power threshold is variable.

In accordance with a first characteristic of the invention, said threshold corresponds to a decreasing amplifier output current with a substantially linear slope up to a predetermined output voltage value and with a substantially linear lower slope above said value.

It is to be noted that flat and linearly sloping power thresholds starting from zero output voltage are already known from the British patent 1 236 449. With the help of ordinary diodes performing a decoupling action respectively for positive and negative voltage swings across the load, this is followed either by a flat current threshold or one with a lower decreasing linear slope. Moreover, the control signal is not a linear function of the power in the output transistor, since when it does not merely depend on the output transistor current, it is additionally a function of the load voltage of the push-pull amplifier and not of the output transistor voltage.

In accordance with a second characteristic of the invention, threshold selection means are provided so that said threshold may correspond to a constant amplifier output current.

In this manner, the threshold can follow a constant amplifier output current limit up to a certain predetermined amplifier output voltage and only thereafter will additional protection circuit means enter into action to cause the limit to decrease in function of the output voltage current with a constant linear slope, the magnitude of which is decreased in a discontinuous manner upon yet a higher predetermined output voltage being reached.

But alternatively, it is also possible to keep the constant current limit for all values of output voltage as long as the amplifier temperature does not exceed a predetermined limit. Only if the temperature becomes excessive, can the discontinuous linear slope threshold become effective, even at the lowest end of the output voltage scale. Thus, this approximation of a maximum predetermined output power threshold is then used over the whole output range but only for a higher range of temperature.

Accordingly, it becomes possible to save power by effectively disconnecting two potentiometers part of the protection circuit and fed by a voltage and by a current which are each related to the respective amplifier output voltage and current. For instance, as long as the temperature is below the predetermined limit, the sensing element is merely associated with a voltage over part of the first potentiometer and which is proportional to the amplifier output current. Thus, it may be arranged to react only upon the predetermined constant current threshold being reached whatever be the value of the output voltage. However, upon both potentiometers being effective in the higher temperature range, the sensing element branched between their tapping points will now react when a threshold output current is reached which is no longer a constant but decreases as the output voltage increases, and this with a broken linear slope which exhibits a discontinuity at a predetermined output voltage value.

This is obtained by a two-terminal element part of the second potentiometer and having a Zener diode characteristic so that current flows therethrough only upon this value being exceeded, a suitable choice of the resistive values of the two potentiometers ensuring a lower slope from then on.

It is to be noted that US patent 4 355 341 published on October 19, 1982 discloses a circuit which protects an output transistor against power overload using a reference current source and it is remarked that the reference current may be a function of temperature so that the maximum output power dissipation may be made to decrease with increasing temperature. Alternatively, it is said this reference current could be sharply reduced upon reaching a predetermined temperature, thereby providing thermal shutdown of the amplifier. Thus, the complete protection circuit would always be active and it is only the characteristic itself which would be modified in function of temperature.

The above mentioned and other objects and features of the invention will become more apparent and the invention itself will be best understood by referring to the following

- 4 -

description of embodiments taken in conjunction with the
accompanying drawings which  represent :

Fig. 1, a circuit diagram of an electronic
push-pull amplifier protection circuit according to a first
embodiment of the invention;

Fig. 2, a collector current versus voltage
characteristic of transistors Q11/14 in Fig. 1;

Fig. 3, a modified version of the circuit of Fig. 1
to enable temperature control;

Fig. 4, a temperature sensing circuit associated
with the protection circuit of Fig. 3;

Fig. 5, a collector current versus voltage
characteristic of transistors Q11/14 in Fig. 3.

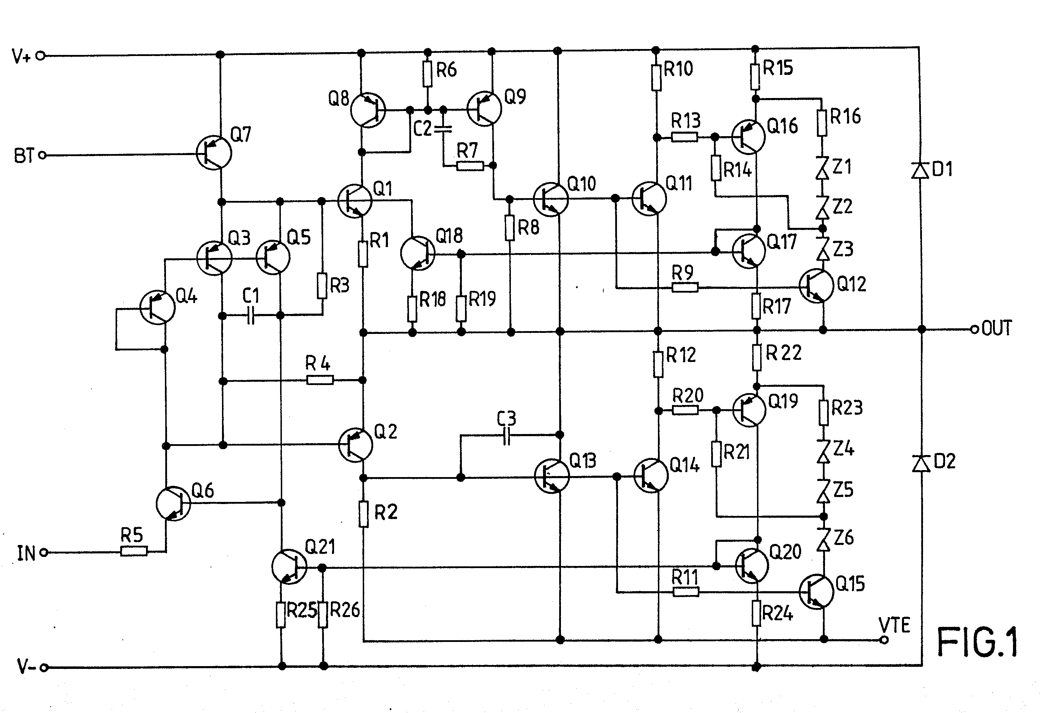

Referring to Fig. 1, the amplifier shown therein is
used as the output stage of an operational amplifier
including also an input  stage and an intermediate stage
which are not represented as they are similar or identical
to those of the operational amplifier described in the
European patent application published under No 0078347
(J. DANNEELS 7-1). As in the latter, the operational
amplifier of which the present amplifier forms part may be
used in a telephone line circuit. It operates with voltages
V+ = O Volts or ground, V- = -48 Volts while VTE has a value
between V+ and V- and is function of the line length. The
present amplifier has an input terminal IN, an output terminal
OUT and a bias terminal BT corresponding respectively to
point 26, terminal OUT and the base of transistor Q27 in Fig.1
of the above patent application. The output terminal OUT is
connected to a first terminal of a two terminal load (not
shown), e.g. a telephone line, the other terminal of which is
connected to the output terminal of a similar amplifier. The
amplifier includes transistors Q1 to Q21, resistors R1 to
R26, capacitors C1 to C3, diodes D1 and D2 and Zener diodes
Z1 to Z6. Transistors Q3, Q5, Q7, Q9, Q12, Q15; Q2; Q11,
Q14 and Q10, Q13 have an emitter surface which is equal to about 2, 4, 5 and 30 times the emitter surface of the other transistors respectively.

The amplifier includes a class B pushpull amplifier circuit of which NPN transistor Q1 and NPN transistor Q2 form the input transistors. The emitter of Q1 is connected to terminal OUT via emitter resistor R1 and that of Q2 directly. Their collectors are coupled to V+ via a collector impedance constituted by a current source active load Q8, Q9 and to VTE via collector resistor R2 respectively. Their bases are interconnected via a cross-over distortion reducing series connected pair of diodes constituted by the emitter-base junctions of PNP transistors Q3 and Q4, Q4 being diode connected and in current mirror configuration with PNP transistors Q3 and Q5. More particularly, the collector of Q4 is connected to its base and to the collector of Q3 and its emitter is connected to the bases of Q3 and Q5. The emitter and collector of Q5 are connected to the bases of Q1 and of NPN transistor Q6 respectively. The collector of Q5 is also connected to the base of Q1 via start-up resistor R3 and via compensating capacitor C1, provided for stability reasons, to the collector of Q3. The latter is also connected to the emitter of Q2 through resistor R4 which shunts the base-emitter junction of Q2. Resistor R4 is provided in order to somewhat reduce the sum of the base-emitter voltages of the transistors Q1 and Q2 which is generally somewhat larger than that of the transistors Q3 and Q4. The collector of transistor Q6 is connected to the junction point of the collectors of Q3, Q4 and to the base of Q2, and its emitter is connected to input terminal IN via resistor R5. This input terminal may be connected to the drive transistor of the intermediate stage (not shown) of the operational amplifier. The base of transistor Q1 is connected to the collector of PNP transistor Q7 whose emitter is connected to V+ and whose base is connected to bias terminal BT. Transistor Q7 forms part of a bias current source (not shown) included in the last mentioned intermediate stage of the operational amplifier.

To be noted that the above described circuit including transistors Q1 to Q4, Q6 and Q7 is substantially known, e.g. from the above mentioned European patent application and from the book "Analysis and design of analog integrated circuits" by P.R. Gray and R.G. Meyer, John Wiley and Sons, 1977, p. 337 and "Analog integrated circuit design" by A.B. Grebene, Van Nostrand Reinhold Company, 1972, p.165.

Because transistors Q3 and Q5 are connected in current mirror configuration with transistor Q4 which delivers equal base currents to Q3 and Q5 the constant current provided by the current source transistor Q7 is equally divided between Q3 and Q5. These transistors have equal emitter currents and equal collector currents when neglecting the base currents of transistors Q1 and Q2. This means that the collector and base currents of transistor Q6 are equal so that this transistor is fully saturated. As a consequence the input IN of the amplifier is in fact connected to the base of transistor Q2 via resistor R5 only.

The collector of transistor Q1 is connected to V+ via a current source active load as already mentioned. This load comprises diode connected PNP transistor Q8 which is connected in current mirror configuration with PNP transistor Q9. More particularly, the collector of Q1 is connected to the collector of Q8 and to the bases of Q8 and Q9 the emitters of which are both directly connected to V+. The bases of Q8 and Q9 are further connected to V+ via leakage resistor R6 and to the collector of Q9 via a compensating filter circuit comprising capacitor C2 and resistor R7 in series. The collector of Q9 is connected to terminal OUT via collector resistor R8. Leakage resistor R6 prevents the operation of Q8, Q9 by leakage current of Q1 as this leakage current must be equal to VBE divided by R6 before Q8 and Q9 can operate. The collector of Q9 is also directly connected to the bases of

NPN power transistor Q10 and NPN transistor Q11 and further connected to the base of NPN transistor Q12 via resistor R9. The emitters of Q10, Q11 and Q12 are all directly connected to terminal OUT and the collectors of Q10 and Q11 are connected to V+ directly and via resistor R10 respectively. As the collector current of power transistor Q10 is about six times that of Q11 and fifteen times that of Q12, transistor Q10 is the effective output transistor of the amplifier.

The collector of Q2, connected to VTE via collector resistor R2 as previously noted, is also directly connected to the bases of NPN power transistor Q13 and NPN transistor Q14. Via resistor R11 it is connected to the base of NPN transistor Q15. The emitters of Q13, Q14 and Q15 are all directly connected to VTE and the collectors of Q13 and Q14 are connected to terminal OUT directly and via resistor R12 respectively. As the collector current of power transistor Q13 is about six times that of Q14 and fifteen times that of Q15, this transistor Q13 is the other main output transistor of the amplifier. PNP transistor Q2 and NPN transistor Q13 form a composite transistor which is known from pp. 133-136 of the above mentioned book by A.B. Grebene. This composite transistor still behaves as a PNP transistor and has a current amplification factor beta which is the product of the betas of the two transistors. To prevent oscillations, a capacitor C3 is connected between the collector of Q13 and the joined collector of Q2 and bases of Q13 and Q14.

The purpose of the above active load Q8/Q9 is to provide a suitable collector impedance for Q1 and to generate at the emitter of transistor Q10 which is connected to terminal OUT a signal which varies in the same sense as that at the emitter of Q1 which is connected to terminal OUT. No such active load has to be connected to the collector of transistor Q2. Indeed, by the direct connection of the collector of Q2 and the base of Q13 the signal at the collector of Q13 which is connected to terminal OUT varies in the same sense as that at the collector of Q2 which is also connected to terminal OUT.

Because the collectors of transistors Q1 and Q2 are coupled to the bases of transistors Q10, Q11, Q12 and Q13, Q14, Q15 respectively only a small base current of Q1 and Q2 is required to drive Q10, Q11, Q12 and Q13, Q14, Q15.

Returning to transistor Q11, its collector is coupled via resistor R13 to the base of PNP transistor Q16 and from there to terminal OUT via a voltage threshold circuit comprising resistor R14, Zener diode Z3 and transistor Q12 in series. The emitter of Q16 is connected to V+ via resistor R15 and to terminal OUT via another voltage threshold circuit comprising the series connection of resistor R16, Zener diodes Z1 and Z2, Zener diode Z3 and transistor Q12 already mentioned. The values of potentiometer resistors R14 and R16 are substantially larger than those of R13 and R15 and in turn, this is true for the latter with respect to that of R10. The collector of Q16 is connected to the collector of the diode connected NPN transistor Q17 which is connected in current mirror configuration with NPN transistor Q18. More particularly, the collector of Q16 is connected to the collector of Q17 and to the interconnected bases of Q17 and Q18, the emitters of which are connected to terminal OUT via resistors R17 and R18 respectively. The interconnected bases of Q17 and Q18 are also connected to terminal OUT via leakage resistor R19 which prevents the operation of Q17, Q18 by leakage current of Q16 in a similar way as R6, the collector of Q18 being connected to the base of transistor Q1. Terminal OUT is also connected to V+ via overload protection diode D1.

Likewise, the collector of transistor Q14 is connected via resistor R20, to the base of PNP transistor Q19 and from there to VTE via a voltage threshold circuit comprising resistor R21, Zener diode Z6 and Q15 in series. The emitter of Q19 is connected to output terminal OUT via resistor R22 and to VTE via a voltage threshold circuit comprising resistor R23, Zener diodes Z4 and Z5, Zener diode Z6 and Q15 already mentioned in series. The collector of Q19 is connected to the collector of the diode connected NPN transistor Q20 which is connected in current mirror configuration with NPN transistor Q21. More particularly, the collector of Q19 is connected to the collector of Q20 and the interconnected bases of Q20 and Q21, the emitters of which are connected to V- via resistors R24 and R25 respectively. The interconnected bases of Q20 and Q21 are also connected to V- via leakage resistor R26 similar to R19 and the collector of Q21 is connected to the base of transistor Q6. Voltage V- is also connected to terminal OUT via protection diode D2 which has the same function as D1.

In the above described amplifier circuit transistors Q1 to Q4, Q7 to Q11, Q13 and Q14 form part of the amplifier proper, whilst the other transistors Q5, Q6, Q12 and Q15 to Q21 form part of a current/power overload protection arrangement for this amplifier and more particularly for the power transistors thereof. This protection arrangement more particularly comprises a first protection circuit Q12, Q16, Q17, Q18 associated to part Q1, Q8-Q11 of the amplifier and a second protection circuit Q15, Q19-21, Q6, Q5 associated to part Q2, Q13, Q14 of this amplifier. Each protection circuit includes a detection circuit made up mainly of transistors Q16, Q12 and Q19, Q15 respectively, and a feedback circuit made up mainly of transistors Q17, Q18 and Q20, Q21, Q6 respectively. Each detection circuit includes two voltage threshold circuits R14, Z3, Q12; R21, Z6, Q15 and R16, Z1-Z3, Q12; R23, Z4-Z6, Q15 respectively.

When transistor Q1 is not conductive, this is true also for Q11 and Q12 so that the associated protection circuit is disabled. Similarly, for transistor Q2 in relation to transistors Q14 and Q15.

0106378

- 10 -

When an input signal is applied to input IN, for instance transistor Q1 of the upper protection circuit becomes conductive, its collector current being mirrored by transistors Q8 and Q9 in the bias resistor R8 of transistors Q10 and Q11. When the bias voltage thus developed in R8 exceeds the $V_{BE}$ of Q10 and Q11 the latter become conductive. For instance, with R8 = 700 ohms this already happens for a collector current I of Q11 equal to about 1 mA. The resistance values have been so chosen that when this bias voltage reaches a value such that the current I is equal to about 10 mA, transistor Q12 becomes saturated in preparation for the connection of potentiometers R10/13/14 and R15/16 to terminal OUT. However, as long as the voltage V between V+ and OUT does not reach the Zener voltage $V_{Z3}$ of Z3 the current cannot flow through resistor R14 and as long as it is lower than the Zener voltage $V_Z$ of Z1, Z2 and Z3 in series, the current cannot flow through resistor R16. For such voltages lower than $V_{Z3}$, the voltage drop across the resistor R10 is used to protect transistor Q11, and therefore also transistor Q10, against current overload. When at least Zener diode Z3 is switched in, the circuit protects against power overload according to a characteristic representing an approximately constant power threshold.

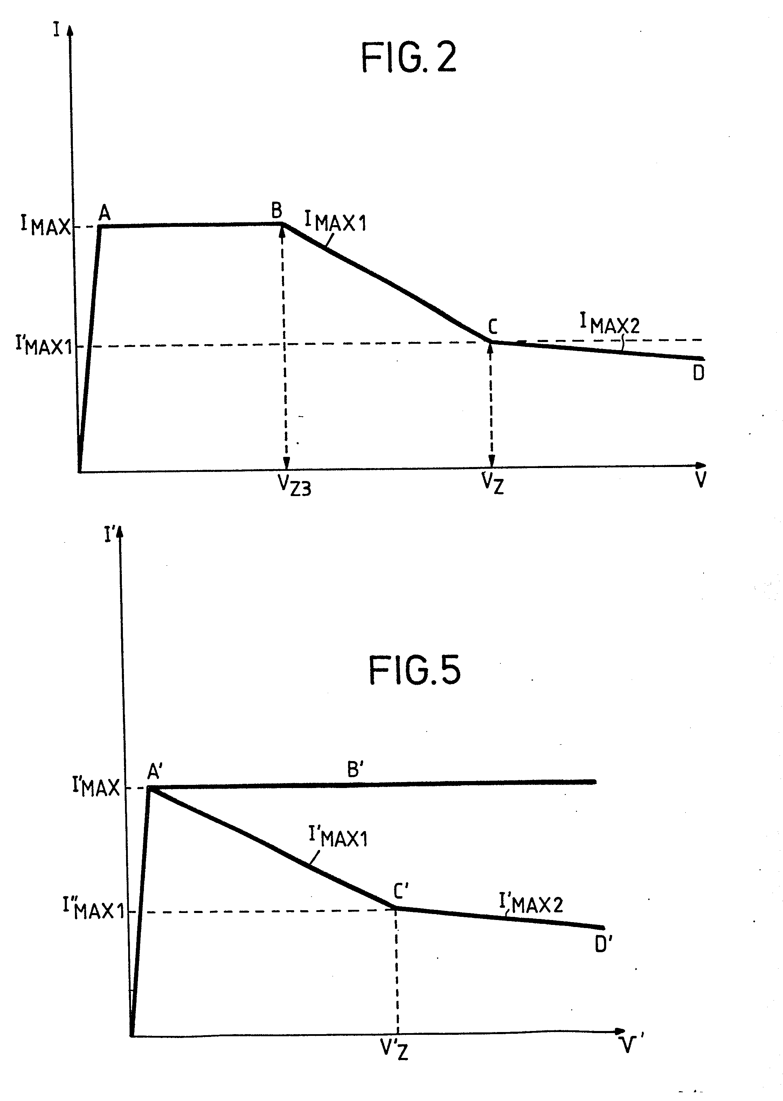

This will now be explained in detail by referring also to Fig. 2 where I, the collector current of Q11, is plotted in function of V, the variable output voltage between terminals V+ and OUT. When Q11 is conductive and as long as V+ is larger than an initial voltage and smaller than the Zener voltage $V_{Z3}$ of Z3, current only flows between V+ and OUT via R10 and Q11. Sensing transistor Q16 becomes conductive when I produces a voltage drop in R10 equal to the base-emitter volrage $V_{BE}$ of Q16. This current is essentially the maximum current allowed because sensing transistor Q16 when becoming conductive will limit the current through

0106378

- 11 -

Q11 by the feedback action to be described later. Because $V_{BE}$ is substantially a constant this is true also for the maximum allowable collector current $I_{MAX}$. Summarizing, for an output voltage V varying between an initial voltage and the Zener voltage $V_{Z3}$ of $Z_3$ the maximum allowable collector current $I_{MAX}$ of Q11 remains substantially constant as shown by AB in Fig. 2. Because the collector current of Q10 is six times that of Q11 the maximum collector current allowed for Q10 is equal to six times that of Q11 and is for instance equal to 120 mA.

When the variable output voltage V across the terminals V+ and OUT becomes larger than the Zener voltage $V_{Z3}$, then there flows between these terminals not only a collector current I but also, when neglecting the base current of Q16 and the collector-emitter voltage of Q12, an additional current

$$I_1 = \frac{V - V_{Z3}}{R10 + R13 + R14} \tag{1}$$

$I_1$ being much smaller than I because R13 and R14 are much larger than R10, e.g. R10 = 50 ohms, R13 = 1.58 kilo-ohms and R14 = 40 kilo-ohms. The sensing transistor Q16 now becomes conductive when I has a maximum value given by

$$I_{MAX1} = \frac{V_{BE}}{R10} - (1 + \frac{R13}{R10}) I_1$$

$$= I_{MAX} - \frac{R10 + R13}{R10(R10 + R13 + R14)} (V - V_{Z3})$$

$$= I_{MAX} - \frac{R13}{R10 \cdot R14} (V - V_{Z3}) \tag{2}$$

the third expression neglecting R10 as compared to R13 and R10 + R13 as compared to R14.

Hence, when V exceeds the voltage $V_{Z3}$ the maximum allowed collector current of Q11 decreases linearly with increasing V, from a value $I_{MAX}$ and with a negative slope substantially equal to $\frac{R13}{R10 \cdot R14}$ (part BC in Fig. 2).

- 12 -

When the variable output voltage V reaches the Zener voltage $V_Z = V_{Z1} + V_{Z2} + V_{Z3}$, the maximum value of the collector current of Q11 becomes equal to

$$I'_{MAX\ 1} = I_{MAX} - \frac{R13}{R10.R14}(V_{Z1} + V_{Z2}) \qquad (3)$$

From that moment on another additional current

$$I_2 = \frac{V-V_Z}{R15 + R16} \qquad (4)$$

starts flowing between the terminals V and OUT via R15, R16, Z1, Z2, Z3 and Q12. This current is also much smaller than I because e.g. R15 = 1.58 kilo-ohms and R16 = 48 kilo-ohms.

The sensing transistor Q16 now becomes conductive when the collector current has a maximum value represented by CD in Fig. 2 and given by

$$I_{MAX2} = \frac{V_{BE}}{R10} - (1 + \frac{R13}{R10})\ I_1 + \frac{R15}{R10}\ I_2$$

$$= I_{MAX1} + \frac{R15}{R10}\ (\frac{V-V_Z}{R15 + R16})$$

$$= I'_{MAX1} + \frac{R13}{R10R14}\ (V_Z-V) + \frac{R15}{R10}\ (\frac{V-V_Z}{R15 + R16})$$

$$= I'_{MAX1} - \frac{R13}{R10R14}\ (1 - \frac{R14R15}{R13R16})\ (V-V_Z) \qquad (5)$$

Apart from the additional current function of $I_2$, the first of the above four expressions for $I_{MAX2}$ is thus similar to the first expression for $I_{MAX1}$ in equation (2). The second follows by using equations (2) and (4) and the third by resorting to equation (3), the fourth and final form taking into account that R15 is small as compared to R16.

Thus, the previous negative linear slope of V given by (2) is now multiplied by the factor $1 - \frac{R14R15}{R13R16}$ which means that when R14R15 is less than R13R16, or more precisely (R10 + R13) R16 if none of the above approximations is used for the resistance values, the current I still decreases with increasing V but more slowly than before.

Hence, after the flat range one obtains an approximation of a hyperbolic current versus voltage characteristic, i.e. a characteristic representing a substantially constant power.

Summarizing, when V increases, the maximum collector current allowed for Q11 remains equal to $I_{MAX}$ until V reaches the voltage $V_{Z3}$. Thereafter this current decreases linearly in such a way that the power consumption remains substantially constant, first with a first slope until V reaches $V_Z$ and thereafter with a second slope which is much smaller than the first one. In other words, the protection circuit first provides protection against a current overload corresponding to $I_{MAX}$ in Q11 and Q10 as soon as Q11 is conductive and afterwards against a power overload according to a substantially constant power characteristic approximated by $I_{MAX1}$ and $I_{MAX2}$ from the moment both Q12 and Z3 are conductive.

Whenever sensing transistor Q16 becomes conductive its collector current is mirrored by the transistors Q17 and Q18 which both become conductive. The conductive transistor Q18 derives base current from Q1 so that this transistor Q1 and therefore also Q10 and Q11, through Q8 and Q9, become less conductive due to this feedback loop action.

The operation of the sensing transistor Q19 is similar to that of Q16 but its influence on PNP transistor Q2 is different because the base current of the latter cannot be limited as that of the NPN transistor Q1 fed by the constant current source provided by Q7. Thus, to avoid too high a power consumption in deviating base current from Q2 when transistors Q19, Q20 and Q21 become conductive, base current is now derived through the saturated transistor, acting as a current-voltage converter, Q6 so that the latter then leaves the saturation region and decreases the input signal applied to Q2 because of its emitter-collector path being connected between R5 and the base of Q2.

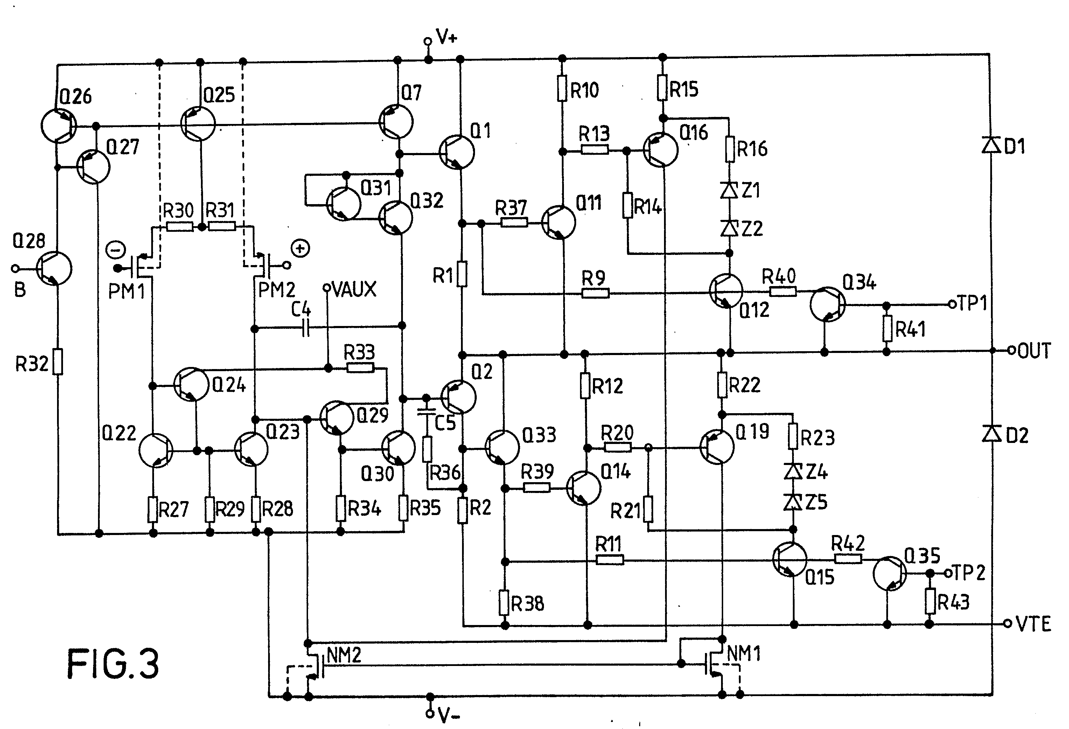

Reference is now made to Fig. 3 showing a modified

- 14 -

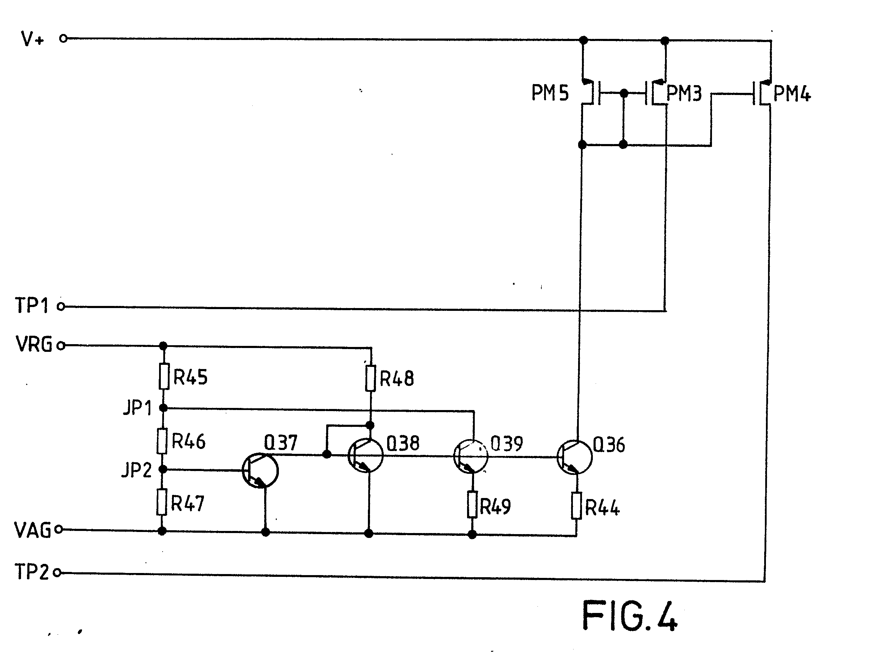

operational amplifier associated with the temperature sensing circuit of Fig. 4 and to Fig. 5 showing the collector current versus output voltage characteristic of transistor Q11/14. In Fig. 3 the elements having a function similar to that of Fig. 1 are indicated by the same reference numerals. The scales of Figs. 3 and 5 are not alike.

The operational amplifier shown includes an input stage (transistors Q22-29), an intermediate stage (transistors Q7, 30) and an output stage (transistors Q1, 2, 11, 14, 31, 32, 33). The input and intermediate stages are of the type disclosed on page 337, Fig. 6.12 of the above mentioned book by P.R. Gray and R.G. Meyer.

The input stage is a differential stage with a single-ended output and includes PMOS transistors PM1 and PM2 whose gate electrodes constitute the inverting and noninverting input terminals - and + of the amplifier respectively. The transistors PM1 and PM2 of which the substrates are connected to V+ as indicated by the dashed lines are biased by a current source comprising NPN transistors Q22, Q23, Q24 connected to V- through their respective emitter resistors R27, R28 and R29. The drain electrodes of PM1 and PM2 are connected to the collectors of Q22 and Q23 respectively whose bases are commoned to the emitter of Q24 having its base connected to the collector of Q22 and its collector to an auxiliary voltage VAUX which is 15 Volts above V-. Transistors PM1 and PM2 have a common active load constituted by PNP transistor Q25 whose emitter is connected to V+ and whose collector is connected to the source electrodes of PM1 and PM2 via resistors R30 and R31 respectively. Transistor Q25 is connected in current mirror configuration with PNP transistor Q7, the bases of Q25 and Q7 being connected to the base of PNP transistor Q26 which together with PNP transistor Q27 and NPN transistor Q28 constitute a current source of the type disclosed on page 4, Fig. 7 of the book "201 Analog IC designs, compiled tested and written

- 15 -

by the staff of Interdesign (Ferranti), Sunnydale, California, 1980. In this current source the base of Q28 is connected to a bias voltage B which is such that a fixed current, e.g. of 60 mA, flows in the collector of Q28 whose emitter is connected to V- via resistor R32. The collector of Q28 is commoned with the collector of Q26 and the base of Q27 whose collector is directly connected to V- and whose emitter is connected to the base of Q26. The emitters of Q26, Q25 and Q7 are all connected to V+.

The differential input stage has a single ended output as the collector of Q23 is connected to the base of emitter follower NPN transistor Q29 whose collector is connected to VAUX through resistor R33, its emitter being biased to V- via resistor R34. Transistor Q29 constitutes a buffer between the input stage and the intermediate stage which includes current source PNP transistor Q7 and NPN transistor Q30 whose emitter is connected to V- through resistor R35 and which provides a large voltage gain. The collectors of Q7 and Q30 constitute the bias input and the signal input of the push-pull output stage, these inputs being connected to the bases of NPN transistor Q1 and PNP transistor Q2 respectively. These bases are interconnected via the series connected base-to-emitter junctions of diode connected NPN transistors Q31 and Q32 whose collectors are commoned to that of Q7. The emitter of Q32 is coupled to the junction point of the drain electrode of PM2 and the collector of Q23 through compensating feedback capacitor C4, whilst the collector of Q2 is connected to its base via a compensating filter comprising capacitor C5 and resistor R36 in series.

In the output stage, generally similar to that of Fig. 1, the collector-to-emitter path of transistor Q1 is connected in series with resistor R1 between V+ and the output terminal OUT, and likewise the emitter-to-collector path of transistor Q2 is connected in series with resistor R2 between terminal OUT and VTE. However, the emitter of Q1 is now coupled to the base of NPN power transistor Q11 via resistor R37. Likewise, the collector of Q2 is coupled to the base of NPN power transistor Q14 through resistor R39 but also through a preceding emitter follower comprising NPN transistor Q33 with its collector and base coupled to the OUT terminal and to the collector of Q2, its emitter being biased to VTE through resistor R38. Transistors Q11 and Q14 replace transistors Q10/11 and Q13/14 of Fig. 1 respectively. Q2 and Q33 together form a compound transistor having a beta factor which is the product of the beta factors of Q2 and Q33. This compound transistor still behaves as a PNP transistor and has a relatively small cut-off frequency.

The power overload protection circuits associated to the transistors Q11 and Q14 are substantially as already shown on Fig. 1 but differ therefrom in that :

- the junction points of R14 and Z2 and of R21 and Z5 are now directly connected to the collectors of Q12 and Q15 respectively, instead of through Zener diodes Z3 and Z6. As a result, and as will be explained later, the I'/V' characteristic (Fig. 5) of the transistors Q11/14 now comprises a current limiting portion A'B' extending over the whole voltage range as an alternative to a power limiting portion B'C'D' with $V'_Z$ now equal to $V_{Z1} + V_{Z2}$;

- the feedback connection from the collectors of both sensing transistors Q16 and Q19 now extends to the base of a same transistor, i.e. buffer transistor Q29 of the input stage. For Q16 this is a direct connection, whereas the collector of sensing transistor Q19 is connected to the drain electrode of diode connected NMOS transistor NM1 whose source electrode is

- 17 -

connected to V- and whose gate electrode
is connected in current mirror fashion to
that of NMOS transistor NM2, the source electrode of which is connected to the base of Q29.
Both substrates of NM1 and NM2 are connected to
V- as indicated by the dashed lines.

To be noted that the differences in the feedback
connections of Fig. 3 and Fig. 1, where the outputs of the
sensing transistors Q16 and Q19 go to the bases of the
individual transistors Q18 and Q21 which are both included in
the output stage is due to the fact that in the circuit of
Fig. 3 all the stages can be continuously maintained in their
operative condition so that it is possible to establish a
feedback connection to a common element of the input stage,
i.e. Q29. In Fig. 1, only the shown output stage is
continuously maintained in the active condition so that it is
necessary to establish a feedback connection from Q16/19
to an element of a corresponding part of the output stage,
i.e. Q18/11. Indeed, it was desirable that the input and
intermediate stages be made inactive when the amplifier is
in the rest condition to save power, such a measure not
being required for the circuit of Fig. 3 because the amplifier
shown therein is of a much simplier design and therefore
consumes less power.

With the above described circuit of Fig. 3, first
the output current through Q11/14 is limited by the resistor
R10/12, as long as transistor Q12/15 is blocked, to a maximum
value $I'_{MAX}$ such that the voltage across such resistors is
equal to the $V_{BE}$ of Q16/19, i.e. to a value of about 120 mA.
This is represented in the I'/V' characteristic of Fig. 5 by
line A'B'. When Q12/15 becomes conductive, the power
protection based on the actual power and not merely the
current is immediately active because of the absence of
Zener diode Z3/6. However, transistor Q12/15 now only
becomes conductive for a base voltage corresponding to a

current through Q11/14 equal to about 10 mA, as in Fig. 1
and when simultaneously the amplifier temperature exceeds
a predetermined value. Indeed, the above current/power
overload protection circuits and more particularly the two
transistors Q12 and Q15 thereof are now additionally coupled
to a common temperature sensing circuit which prevents them
from being saturated by the applied base current as long as
the amplifier temperature does not exceed a predetermined
value.

The base of transistor Q12 is connected between
resistors R9 and R40 which are branched in series with
the collector-to-emitter path of NPN transistor Q34 across
R1, the base of Q34, i.e. terminal TP1, being connected to
OUT through bias resistor R41. Likewise, the base of Q15
is connected between resistors R11 and R42 which are branched
in series with the collector-to-emitter path of NPN
transistor Q35 across R38, the base of Q35 being connected
to VTE via bias resistor R43. As shown in Fig. 4, V+ is
connected to TP1 and TP2 via the source-to-drain paths of
PMOS transistors PM3 and PM4 which are connected in current
mirror configuration with a diode-connected PMOS transistor
PM5 the source-to-collector path of which is connected between
V+ and terminal VAG in series with the collector-to-emitter
path of NPN transistor Q36 and resistor R44. The potential
at VAG is half-way between V- and VAUX. A potentiometer
comprising resistors R45, R46 and R47 in series is connected
between terminals VRG and VAG. The potential between the
two is temperature independent and equal to 2.4 Volts, i.e.
twice the so-called transistor bandgap voltage $V_{BE} = 1.2$ Volt.
In this way a temperature independent voltage of about 0.4
Volt is established at the junction point JP2 of R46 and
R47 which is connected to the base of a temperature sensing
NPN transistor Q37 whose collector is commoned to that of
NPN transistor Q38 and therefore to the base thereof since it
is diode connected and forms part of a current source.

Its collector is connected to VRG via resistor R48 and its
emitter is directly connected to VAG. Its base is also
connected in current mirror configuration to the bases of the
above mentioned transistor Q36 and of a further transistor
Q39. The emitter of Q39 is connected to VAG through
resistor R49 and its collector is connected to the junction
point JP1 of R45 and R46.

The temperature sensing transistor Q37 is mounted
in the immediate proximity of the output transistors Q11 and
Q14 so that the temperature sensed is function of the output
current I' flowing through this transistor and of course
also of the surroundings.

The temperature sensing circuit operates as
follows.

As long as the temperature sensed by transistor
Q37 does not exceed a predetermined maximum,
e.g. 160°C, the output current is limited by R10 and R12.
Sensing transistor Q37 then remains blocked and does not
prevent the operation of current source transistor Q38 whose
constant collector current is mirrored in the transistors
Q39 and Q36 so that these have the same collector current.
That of Q36 flows in PM5 and is again reflected in PM3 and PM4
so that the same current flows from V+ to OUT via PM3, TP1
and R41 and to VET via PM4,TP2 and R43. As a consequence
Q34 and Q35 are made conductive, so that potentiometers R9,
R40 and R11, R42 are connected across R1 or R38. The
values of these resistors have been so chosen that the
operation of Q12 and Q14 is then inhibited independently
of the voltage applied to its base.

When the temperature increases the base-to-emitter
voltage $V_{BE}$ of transistor Q37 decreases and when this voltage
becomes lower than 0.4 Volts, e.g. at 160°C, at the junction
point JP2, transistor Q37 becomes conductive and thus
short-circuits the bases of transistors Q38, Q39 and Q36 to
VAG. These transistors are therefore all blocked and the same is true for PM3, PM4 and PM5 and for Q34 and Q35 so that the operation of the transistors Q12 and Q15 is no longer inhibited by the temperature control and only dependent on the current control, as in Fig. 1. Because of the absence of a Zener diode Z3/Z6 the power protection already becomes effective from point A' of the characteristic and varies as represented in dotted lined by A'C'D' in Fig. 5. In a way similar to Fig. 2, the slope changes at C', when V' is equal to $V'_Z$, this time equal to $V_{Z1} + V_{Z2}$.

From the above it follows that with the circuit of Figs. 3, 4 and 5, either the output current or the actual output power of Q11 and Q14 is limited and that this power limitation only occurs when the output current and the temperature sensed are both above predetermined values.

In order to prevent an oscillatory condition for the temperature control circuit a certain amount of hysteresis is provided by the circuit involving Q39. As soon as Q39 is blocked in the way described above, it no longer draws current through R45 so that the voltage at JP1 and hence at JP2 increases to a value which, for JP2, is larger than the 0.4 Volt present prior to the operation of Q37. This means that Q37 only becomes blocked again when the temperature drops to a value, e.g. 130°C, for which the $V_{BE}$ of Q37 has increased above this larger voltage value.

The operation of the protection circuits, with Q12 or Q15 conductive or not, is as follows. In case the amplifier delivers a current from V+ (source) to a load via R10, Q11 and OUT which is sufficiently high to make current sensing transistor Q16 conductive the latter supplies an additional base current to buffer transistor Q29, this current flowing from V+ to V- via R15, Q16 the base-to-emitter junction of Q29 and resistor R34. As a consequence, Q29 becomes more conductive and the same is true for transistor Q30. The latter thus draws through Q31, Q32 a

- 21 -

larger part of the constant current provided by Q7 so that less current is delivered to Ql which therefore becomes less conductive. Also, the current flowing in Q11 is therefore reduced, as required. In case a current flows from a load (sink) to VTE in the amplifier via OUT, R12 and Q14 which is sufficiently high to make current sensing transistor Q19 conductive, the latter supplies to NM1 a current which is reflected to NM2. Thus base current is now drawn to V- from buffer transistor Q29 which therefore becomes less conductive and the same is true for Q30. The latter thus draws a smaller part of the constant current provided by Ql, 31, 32 (because Ql is off) so that Q2 becomes less conductive and the current flowing in Q14 is therefore also reduced, as required.

Another possible advantage of the embodiment of Figs. 3 to 5 is that no measures must be provided to avoid incorrect operation due to some transient conditions. For instance, when the amplifier of Fig. 1 operating as per Fig. 2 is connected to a subset via a telephone line, without extra precautions, such a protection circuit might react to the transient condition produced upon the handset being taken off the cradle. This might unduly limit the line current to a value given by the constant power characteristic before a DC current regulating circuit associated to the amplifier would be able to establish a wanted line current different from the established one. This is avoided for the circuits of Figs. 3 and 4 since therein the output current is initially not limited by curve A'C'D' but can extend as far as A'B' (Fig. 5).

While the principles of the invention have been described above in connection with specific apparatus, it is to be clearly understood that this description is made only by way of an example and not as a limitation on the scope of the invention.

- 22 -

CLAIMS

1) Electronic power overload protection circuit adapted to limit the output power of a signal amplifier (Q1/2, 10/13, 11/14) with the help of a sensing element (Q16/19) part of a feedback circuit (Q17/20, 18/21,6) for said amplifier and which becomes conductive upon a predetermined maximum output power threshold being reached, characterized in that said threshold corresponds to a decreasing amplifier output current with a substantially linear slope up to a predetermined output voltage value and with a substantially linear lower slope above said value.

2) Electronic power overload protection circuit according to claim 1, characterized in that said sensing element (Q16/19) has its control input branched across part (R10, 13/12, 20) of a potentiometer (R10, 13, 14/12, 20, 21) fed by a voltage (V+/VTE, OUT) and by a current (R10/12) which are each related to the respective output voltage and current from said amplifier so that a voltage proportional to said output current appears across said part.

3) Electronic power overload protection circuit according to claim 2, characterized in that said control input has its first terminal connected to the junction of the first (R13/20) and second (R14/21) parts of said potentiometer and its second terminal connected to the junction of the first (R15/22) and second (R16/23) parts of a second potentiometer fed by a voltage (V+/VTE, OUT) derived from said amplifier output and with the second part of said second potentiometer including a two-terminal element having a Zener diode characteristic (Z1, 2, 3/4, 5, 6) defining said predetermined output voltage value.

4) Electronic power overload protection circuit according to claim 3, characterized in that said first and second control input terminals are the base and emitter of a sensing transistor (Q16/19).

5) Electronic power overload protection circuit according to claim 2, characterized in that the output circuit of a switching transistor (Q12/15) is in series with said potentiometer (R10, 13, 14/12, 20, 21) and that its input circuit is fed by current related to that from said amplifier output  (Q10/13, 11/14).

6) Electronic power overload protection circuit according to claim 3, characterized in that the resistive value (R14) of the second part of said first potentiometer divided by that (R16) of the second is smaller than that of the first part (R10 + R13) of said first potentiometer divided by that (R15) of the second thereby ensuring said lower slope for an amplifier output voltage above said predetermined value.

7) Electronic power overload protection circuit according to claim 3, characterized in that the resistive values of the second parts of said first (R14) and second (R16) potentiometers are of a higher order of magnitude than those (R13 and 15) of the first parts of said potentiometers which, in turn, are of a higher order of magnitude than that of a resistance (R10) in series with said first part of said first potentiometer, with said current related to the output from said amplifier flowing through said series resistance.

8) Electronic power overload protection circuit adapted to limit the output power of a signal amplifier (Q1/2, 10/13, 11/14) with the help of a sensing element (Q16/19) part of a feedback circuit (Q17/20, 18/21, 6) for said amplifier and which becomes conductive upon a

- 24 -

predetermined maximum output power threshold being reached, characterized in that threshold selection means (Q12, 34/15, 35) are provided so that said threshold may correspond (R10/12) to a constant amplifier output current.

9) Electronic power overload protection circuit according to claim 8, characterized in that amplifier temperature sensing means (Q37) are provided to prevent said threshold from corresponding to said constant amplifier output current once the temperature exceeds a predetermined maximum (160°C).

10) Electronic power overload protection circuit according to claims 1 and 9, characterized in that said threshold follows said linear slopes once the temperature exceeds said maximum.

11) Electronic power overload protection circuit for a push-pull amplifier, according to claim 1 or 8, characterized in that said signal amplifier comprises an input differential stage (PM1/2) a single ended signal output of which is connected to the input of a buffer amplifier (Q29) feeding (Q30) a push-pull output stage (Q1,11/2, 14) of said amplifier, coupling means (NM 1/2) being provided to said buffer input so that said sensing elements (Q16/19) are able to couple either the first or the second pole of a DC source (V+, V-) to said buffer input so as to deliver (Q16) or withdraw (Q19) current upon said sensing element becoming conductive.

12) Electronic power overload protection circuit according to claim 11, characterized in that said output stage includes first (Q1) and second (Q2) push-pull input transistors having intercoupled (Q31/32) bases which are respectively fed by a constant current source (Q7) and by the output (Q30) of said buffer amplifier, each of said input transistors being respectively coupled to an output transistor (Q11/14) associated to respective sensing elements able to couple said first (V+) and second (V-) poles of said buffer input either directly (Q16, V+) or indirectly (Q19, V-) through said coupling means (NM1/2) arranged as a current mirror.

13) Electronic power overload protection circuit according to claim 11, characterized in that said buffer amplifier includes a compensating capacitance (C4) between its output (Q30) and input (Q29).

14) Electronic power overload protection circuit according to claims 5 and 9, characterized in that said temperature sensing means (Q37) control a transistor (Q34/35) whose output circuit normally short-circuits the input circuit of said switching transistor (Q12/15) thereby preventing the latter from being conductive unless said predetermined maximum temperature is exceeded.

15) Electronic power overload protection circuit according to claim 14, characterized in that the output circuit of said temperature sensing means (Q37) is coupled in shunt across the input circuit of a diode connected current source transistor (Q38) whose base is coupled through current mirror circuits (Q36, PM 3, 4,5) to the base of said short-circuiting transistor (Q34/35).

16) Electronic power overload protection circuit according to claim 15, characterized in that a transistor (Q37) constituting said temperature sensing means has its collector connected to the bases of said current source transistor (Q38) and of a further transistor (Q39) whose collector is biassed by a first tapping point (JP1) of a potentiometer branched across a temperature independent DC potential source and having a second tapping point (JP2) connected to the base of said temperature sensing transistor, the emitters of all three transistors being connected to one pole of said DC source, said temperature sensing transistor becoming conductive when the temperature goes above said predetermined maximum (160°C) but exhibiting hysteresis in becoming blocked when the temperature goes below a predetermined minimum (130°C).

17) Temperature controlled means, characterized in that a temperature sensing transistor (Q37) constituting a temperature detector has its collector connected to the bases of a diode-connected current source transistor (Q38) and of a further transistor (Q39) whose collector is biassed by a first tapping point (JP1) of a potentiometer branched across a temperature dependent DC potential source and having a second tapping point (JP2) connected to the base of said temperature sensing transistor, the emitters of all three transistors being connected to one pole of said DC source, said temperature sensing transistor becoming conductive when the temperature goes above said predetermined maximum (160°C) but exhibiting hysteresis in becoming blocked when the temperature goes below a predetermined minimum (130°C), the base of said current source transistor being coupled to one or more output control terminals (TP 1/2) through current mirror circuits (Q36, PM 3, 4,5).

1/4   0106378

FIG.1

L. BIENSTMAN 1/2

# FIG.2

# FIG.5

FIG.3

L. BIENSTMAN 1/2

3/4

0106378

FIG.4

PM4 PM3 PM5 Q36 Q39 Q38 Q37 R44 R49 R48 R45 R46 R47

V+ TP1 VRG JP1 JP2 VAG TP2

L. BIENSTMAN 1/2

0106378

**EUROPEAN SEARCH REPORT**

Application number

EP 83 20 1226

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | DE-B-1 811 765 (RCA)<br>* Figures 3, 4; column 5, lines 7-40 * | 1 | H 03 F 1/52 |
| A | DE-A-2 710 762 (PIONEER)<br>* Figure 1; page 7, lines 9-22 * | 9 | |
| A | US-A-3 678 408 (T. SUZUKI)<br><br>* Figures 1, 13 * | | |
| A | US-A-4 053 996 (B.D. SCHERTZ et al.)<br>* Figure 2 * | | |
| A | US-A-4 021 701 (R.B. DAVIES)<br><br>* Figure 1 * | | TECHNICAL FIELDS SEARCHED (Int. Cl. ³)<br><br>H 03 F 1/52 |
| A | US-A-3 668 545 (D.R. VON RECKLINGHAUSEN)<br>* Figures 7, 8; column 5, line 68 - column 6, line 9 * | | |

The present search report has been drawn up for all claims

| Place of search<br>BERLIN | Date of completion of the search<br>02-12-1983 | Examiner<br>BREUSING J |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82